# EUROPEAN PATENT APPLICATION

(11) **EP 4 730 946 A1**
(43) Date of publication of application: **22.04.2026**
(21) Application number: 24306720.4
(22) Date of filing: 17.10.2024
(51) Int. Cl.: H10D 1/00, H01G 4/33, H10D 1/68, H01L 21/02

(54) **METHOD OF FORMING AN INTEGRATED DEVICE BY PATTERNING A BARRIER AFTER ANODIZATION**

(71) Applicant: Murata Manufacturing Co., Ltd., Nagaokakyo-shi, Kyoto 617-8555 (JP)
(72) Inventor: JOLIVET, Aline, 14000 CAEN (FR); LEMENAGER, Maxime, 14000 CAEN (FR); TANAY, Florent, 14000 CAEN (FR)
(74) Representative: Cabinet Beau de Loménie

(57) **Abstract**

The invention concerns a method of forming at least one integrated device comprising:
depositing a metal barrier layer (103) on a non-conducting substrate (100),
depositing an anodizable metal layer (104) on the metal barrier layer,
obtaining at least a first porous region (105A) comprising a plurality of substantially straight pores that extend from a top surface of the first porous region towards the metal barrier layer by anodizing the anodizable metal layer (104),
depositing, on the first porous region(105A), an etching mask (EM) having at least one opening (OP) defining an etching zone,
obtaining an insulating region (V) by etching the metal barrier layer located at the bottom of the etching zone through the opening of the etching mask so as to reach the substrate,
forming said integrated device inside the pores of the first porous region.

## Description

### Field of the Invention

The present invention relates to the field of integration and, more particularly, to electronic products, related semiconductor products, and their methods of manufacture.

The present invention more precisely relates to electronic components comprising at least one porous region in which, for example, capacitors are arranged.

### Technical Background

Silicon passive integration technologies are nowadays accessible for industrial design. For example, the PICS technology developed by Murata Integrated Passive Solutions allows integrating high density capacitive components into a silicon substrate. According to this technology, tens or even hundreds of passive components can be efficiently integrated into a silicon die.

In their work entitled "Nanotubular metal-insulator-metal capacitor arrays for energy storage" (published in Natural technology, May 2009), P. Banerjee *et al.* describe a metal-insulator-metal (MIM) structure formed in a porous anodic material, such as porous anodic alumina (PAA) for example. The successive layers of conductive material, dielectric material, and then conductive material follow the contours of the porous material resulting in the MIM structure being embedded inside the pores of the porous material. Banerjee's PAA embedded structure however suffers from high Equivalent Series Resistance (ESR) and limited capacitance density due to pores dimensions limiting the thickness and the surface of the layers.

Generally, PAA embedded structures as described above result from embedding a structure (e.g., a MIM capacitive stack) inside a porous region above a substrate, such as a silicon wafer. Typically, the porous region results from anodizing a thin layer of metal, such as aluminum, deposited above the substrate. The anodization converts the aluminum layer into porous anodic alumina. Typically, the porous region is formed with any shape (as viewed from the top) and extends across the alumina layer in a direction perpendicular to the wafer surface.

There exists a need for components including multiple integrated devices such as capacitors each having specific properties. More precisely, it is desirable to have electrically insulated adjacent capacitors arranged on a same substrate, which may have different capacitance values so that they can be used for different applications. By way of example, capacitive arrays comprising multiple different capacitors may be used to decouple various voltage domains. To achieve this, it is necessary to electrically insulate the top and bottom electrodes of adjacent capacitors.

Document WO 2015/063420 A1 discloses a solution for producing a plurality of different capacitors (at least in terms of capacitance) on a same substrate. In this document, the bottom electrodes of the capacitors can be formed above a patterned metal barrier layer, with insulation between the portions of metal barrier.

Document EP 3680931 proposes using a patterned metal barrier layer and an underlying insulating layer to obtain a lateral isolation surrounding capacitors. In this document, the substrate is conductive to bring current for the anodization.

In these two documents, prior to depositing the layer of anodizable metal, it is necessary to pattern the metal barrier layer, and to deposit an insulating material. Such solutions are not only complex to perform, but they also have an impact on the subsequent anodization step.

Indeed, anodization is usually performed with the anodizing potential connected to the metal barrier layer. When portions of metal barrier layer are insulated from one another, it has been observed that the anodization may be incomplete through the anodizable metal layer: there remain portions of aluminum between the metal barrier layer and the porous regions.

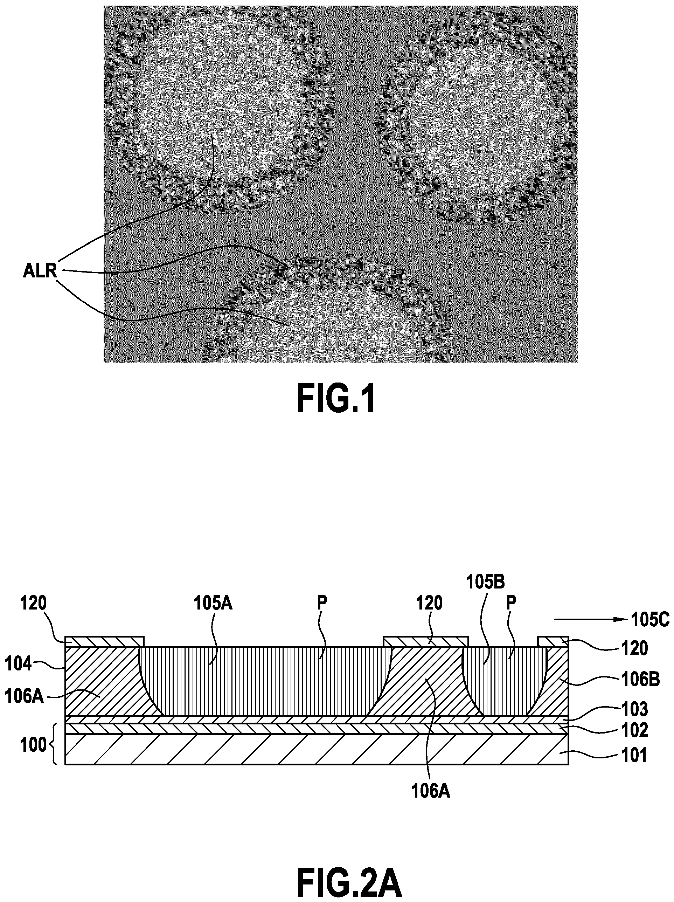

This can be observed on figure 1 that illustrates defects at the interface between a metal barrier layer made, for example, of tungsten, and a porous region comprising alumina. On this figure, obtained by optical microscopy, the circular structures are porous regions formed above an electrically floating tungsten portion. These structures are speckled with aluminum residues (ALR) which could lead to short circuits.

These solutions being unsatisfactory leading to a need for other solutions.

### Summary of the Invention

To this end, the invention provides a method of forming at least one integrated device comprising:
depositing a metal barrier layer on a non-conducting substrate,
depositing an anodizable metal layer on the metal barrier layer,
obtaining at least a first porous region comprising a plurality of substantially straight pores that extend from a top surface of the first porous region towards the metal barrier layer by anodizing the anodizable metal layer,
depositing, on the first porous region, an etching mask having at least one opening defining an etching zone,
obtaining an insulating region by etching the metal barrier layer located at the bottom of the etching zone through the opening of the etching mask so as to reach the substrate,
forming said integrated device inside the pores of the first porous region.

Contrary to known solutions, the present method is easy to implement. Indeed, in the method according to the invention, there is no need to form bottom electrodes of the integrated devices on a patterned metal barrier layer, with insulation between the portions of metal barrier, or to use a patterned metal barrier layer and an underlying insulating layer to obtain a lateral isolation surrounding the integrated devices.

This is made possible because, in the present method, the patterning of the metal barrier layer is done after the anodization step is completed. Consequently, the method of the invention neither require chemical-mechanical polishing (CMP) of the bottom collector electrode and of the metal barrier layer in order to flatten the top surface of the metal barrier layer to enable the deposition of the anodizable metal layer, nor the removal of some regions of the substrate in order to expose the bottom of the metal barrier layer to enable its patterning as it may be the case in existing solutions.

In order to pattern the metal barrier layer, the present method relies on the use of an etching mask deposited on top of the anodizable metal layer after the completion of the anodization step. The metal barrier layer is then patterned by etching the regions of the metal barrier located at the bottom of a given porous region obtained during the anodization step and above which the etching mask present an opening.

Advantageously, since the patterning of the metal barrier layer is done after the anodization step, the amount of metal residue remaining between the anodic porous oxide regions and the metal barrier layer is limited.

In particular implementations, depositing the metal barrier layer comprises:
depositing a first layer of a first metal on the non-conductive substrate, and
depositing at least a second layer made of a second metal on said first layer.

Such a multi-layer metal barrier layer offers a better electrical contact as well as a lower electrical resistance.

For example, the first layer may be a titanium layer and the second layer may be a tungsten layer.

In particular implementations, when the etching mask is disposable, the method comprises a step of removing the etching mask prior to forming said integrated device.

In this case, the etching mask consists for example in a resin layer deposited on the anodizable metal layer. More particularly, the resin is photosensitive.

In particular implementations, further comprising obtaining at least a second porous region, the first and the second porous regions being separated by a first unanodized metal region.

In another aspect, the invention also provides an integrated device comprising:
a metal barrier layer on a non-conducting substrate,
an anodizable metal layer deposited on the metal barrier layer,
   said anodizable metal layer comprising at least a first porous region comprising a plurality of substantially straight pores that extend from a top surface of the first porous region towards the metal barrier layer,
an insulating region, located at the bottom of the first porous region, in which the metal barrier layer was removed so as to reach the substrate.

This integrated device can be obtained by means of any one of the above defined implementations of the method according to the present invention.

In particular implementations of the integrated device, the integrated device comprises an etching mask on the anodizable metal layer, said etching mask having at least one opening located above said insulating region.

In particular implementations of the integrated device, the etching mask is a hard mask.

In particular implementations of the integrated device, the etching mask is a resin layer.

In particular implementations of the integrated device, when the substrate comprises a plurality of layers, the layer on which the metal barrier layer is deposited being a non-conducting layer.

In particular implementations of the integrated device, the metal barrier layer comprises:
a first layer of a first metal on the non-conductive substrate, and
at least a second layer made of a second metal on said first layer.

In particular implementations of the integrated device, the metal barrier layer is etched so as to obtain at least two electrical contacts connected by at least one conductive line.

In particular implementations of the integrated device, comprising, inside the pores of the porous region, a stacked capacitive structure (110A) comprising a bottom electrode layer (111) in electrical contact with the metal barrier layer at the bottom of the pores, a top electrode layer (113), and a dielectric layer (112) arranged between the bottom and the top electrode layer, so as to form at least one capacitor.

In another aspect, the invention also provides a wafer comprising a plurality of integrated devices according to the invention.

### Brief Description of the Drawings

Further features and advantages of the present invention will become apparent from the following description of certain embodiments thereof, given by way of illustration only, not limitation, with reference to the accompanying drawings in which:
- Figure 1, already described, show structures according to the prior art,
- Figure 2A, figure 2B and figures 3 to 6 show the steps of the method for manufacturing a device according to an example,
- Figure 7A, figure 7B and figure 7C show top views of different devices manufactured according to the invention.

### Detailed Description of Example Embodiments

The steps for fabricating an integrated device comprising multiple capacitors will be described hereinafter.

Figure 2A is a side view of a structure comprising a substrate 100. This structure comprises a semiconductor portion 101 (typically silicon) on which an insulating layer 102 (typically silicon dioxide SiO₂) is formed. In other embodiments, the substrate 100 comprises only one layer made of non-conducting material. In these embodiments, the substrate 100 may, for example, be a layer of silicon or a layer of dielectric material such as glass.

A metal barrier layer 103 is deposited on the insulating layer 102. In a particular implementation, the metal barrier layer 103 can be deposited directly on the substrate 100. In this case, there is no insulating layer 102 as the substrate 100 itself is non-conducting.

The metal barrier layer 103 can comprise tungsten. It is to be noted that other metals may be used, provided that they form an oxide without formation of pores under anodization conditions to stop the formation of pores such as titanium. The metal barrier layer 103 is continuous and covers the entirety of the top surface of the substrate 100 or the insulating layer 102.

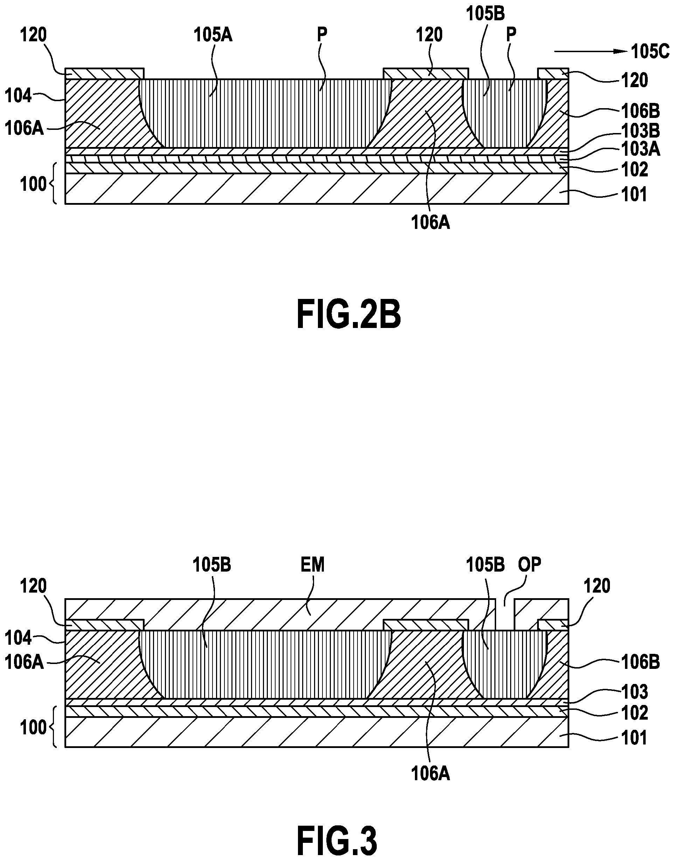

In a particular implementation, the metal barrier layer 103 comprises a plurality of layers. For example, a first layer 103A made of a first metal convers the entirety of the top surface of the substrate 100 or the insulating layer 102, and at least a second layer 103B made of a second metal convers the entirety of the top surface of the first layer 103A as shown on figure 2B. In this example, the first layer 103A can comprise titanium while the second layer can comprise tungsten.

An anodizable metal layer 104 is deposited on top of the metal barrier layer 103, 103B. The anodizable metal layer 104 can be a layer made of aluminum. Anodic porous oxide regions, or porous region, are then formed in the anodizable metal layer 104 by selectively anodizing certain regions of the anodizable metal layer 104. Thus, anodizable metal layer 104 comprises a first porous region 105A and at least a second porous region (105B).

In a particular implementation, the whole anodizable metal layer 104 is anodized and thus forms a unique porous region 105A covering the entirety of the top surface of the metal barrier 103, 103B.

In the following sections of the present document, only the implementation where a plurality of porous regions 105A, 105B are formed in the anodizable metal layer 104 will be described. However, everything described applies as well to the implementation where a single porous regions 105A is formed in the anodizable metal layer 104.

The first porous region 105A and the second porous region 105B are separated by a first unanodized region 106A. In a particular implementation, the second porous region 105B is separated from a third porous region 105C (not represented on figures 2A, 2B) by a second unanodized region 106B.

As already discussed, the porous regions 105A, 105B, 105C are formed by anodization of the anodizable metal layer 104, this anodization being performed until the pores P formed during the anodization reach the metal barrier layer 103, 103B. When the pores P reach the metal barrier layer 103, 103B, the metal comprised in the metal barrier layer 103, 103B is oxidized. The resulting oxide, such as tungsten oxide, then plugs the bottom ends of the pores P stopping the anodization process.

As explained above, a selective anodization can be carried out in the anodizable metal layer 104. In order to selectively anodize the anodizable metal layer 104, an anodization mask 120, also called a hard mask 120 is placed on the surface of the anodizable metal layer 104. The anodization mask 120 can be implemented using the method disclosed in document WO 2019/202046 (possibly with another suitable material for the anodization mask). Such an anodization mask 120 comprises openings defining the regions 105A, 105B of the anodizable metal layer 104 to be anodized.

When the whole anodizable metal layer 104 is anodized, such a hard mask 120 is not needed.

Once the anodization process is complete, i.e. when the pores P formed during the anodization reach the metal barrier layer 103, 103B, an etching mask EM is placed on top of the anodizable metal layer 104 as represented on figure 3 which shows the structure after the anodization step is completed.

The etching mask EM comprises at least one opening OP located on the second porous region 105B. The surface of the opening OP of the etching mask EM can be lower than or equal to the surface of the second porous region 105B. The opening OP of the etching mask can form patterns defining tracks, or circuit lines, intended to electrically connect a plurality of integrated devices.

Once the etching mask EM is placed on top of the anodizable metal layer 104, the region of the metal barrier layer 103, 103B which is accessible through the pores P of the second porous region 105B that are not covered by the etching mask EM is etched. Etching the metal barrier layer 103 consists in removing the metal barrier layer 103, 103B, 103A so as to reach the substrate 100.

The oxide resulting from the anodization of the metal barrier layer 103, 103B, such as tungsten oxide, which plugs the bottom ends of the pores P is removed as well during this etching process.

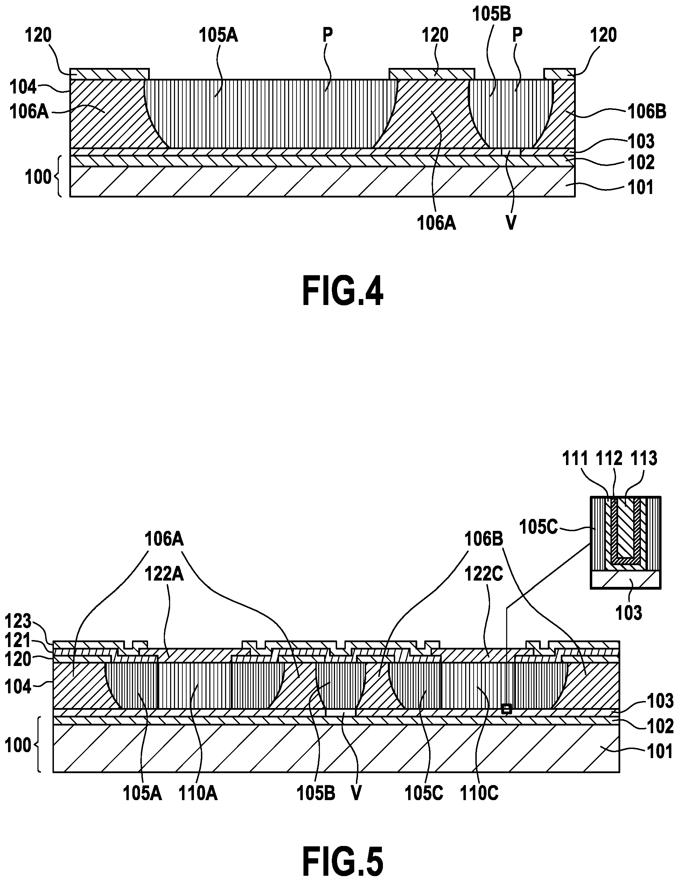

The etching of the metal barrier layer 103, 103A, 103B, creates an empty space V at the bottom of the second porous region 105B as can be seen on figure 4 which shows the structure after the etching step is completed.

In particular implementations, the etching mask EM is disposable and can be removed after the completion of the etching process. Such a disposable etching mask EM can be a photosensitive resin layer deposited by spin coating on the anodizable metal layer 104. In order to remove the etching mask EM, a solvent, called a developer, is applied to the surface of the anodizable metal layer 104.

In other particular implementations, the etching mask EM is a hard mask deposited on the anodizable metal layer 104.

In order to form at least one integrated device, such as a capacitor or an inductance, etc., in the first porous region 105A and in the third porous region 105C, a third hard mask 121 is deposited on top of the anodizable metal layer 104 as represented on figure 5.

This third hard mask 121 enables the selection, in the first porous region 105A and in the third porous region 105C, of groups of pores P intended to accommodate the integrated devices. To this end, the hard mask 121 comprises a first opening located on the first porous region 105A and at least a second opening located on the third porous region 105C. The surface of the openings of the third hard mask 121 can be lower than or equal to the surface of the porous regions 105A, 105C. In the example shown on figures 2 to 6, the surface of the openings of the third hard mask 121 is smaller than the surface of the porous regions 105A, 105C. The third hard mask 121 can be analogous to the one of document EP 3567645.

Prior to forming an integrated device in one of the porous regions, the oxide resulting from the anodization of the metal barrier layer 103, 103B, which plugs the bottom ends of the pores P is removed so that the pores P in which the oxide plugs are removed open onto the metal barrier layer 103, 103B.

In order to form, for example, a first and a second capacitors, a first stacked capacitive structure 110A is deposited in the pores P of the first porous region 105A accessible through the opening of the third hard mask 121, and a second stacked capacitive structure 110B is deposited in the pores P of the third porous region 105C accessible through the opening of the third hard mask 121.

The bottom of a single pore P in which the capacitive structures are deposited is zoomed-in in the top right corner of figure 5.

The stacked capacitive structures110A, 110B include a bottom electrode layer 111 in electrical contact with the metal barrier layer 103 at the bottom of the pores P (or a portion of the pores P if all the pores P do not open onto the metal barrier layer 103), a top electrode layer 113, and a dielectric layer 112 arranged between the bottom electrode layer 111 and the top electrode layer 113, to form the two capacitors.

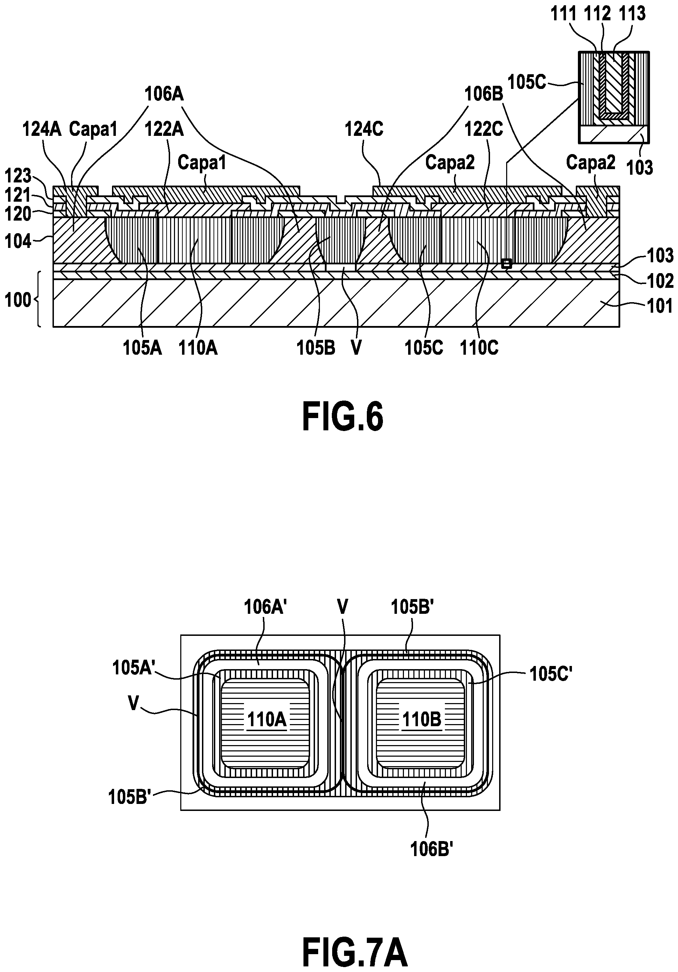

As represented on figure 6, the top electrode layer 113 of the two capacitors is electrically accessible from the top side of the integrated device. A first metal contact 122A is then formed above the first stacked capacitive structure, in electrical contact with the top electrode layer of this capacitor. A second metal contact 122C is formed above the second stacked capacitive structure, in electrical contact with the top electrode layer of this capacitor. A passivation layer 123 is then formed and patterned on top of the third hard mask 121 and of the metal contacts 112A, 122C.

A first electrical connection 124A is formed between the top electrode layer of the first capacitor, through the first metal contact 122A, and the first unanodized region 106A through an opening in the passivation layer 123 and the two hard masks 120, 121.

A second electrical connection 124C is formed between the top electrode layer of the second capacitor through the second metal contact 122C and the second unanodized region 106B through an opening in the passivation layer 123 and the two hard masks 120, 121.

Figure 7A is a top view of two capacitors obtained by implementing the method of the invention. In this example, the anodizable metal layer 104 is selectively anodized.

On figure 7A, a first capacitive structure 110A is surrounded by a first porous region 105A'. An unanodized region 106A', which is surrounded by a second porous region 105B', surrounds the first porous region 105A'.

A second capacitive structure 110B is surrounded by a porous region 105C'. An unanodized region 106B', which is surrounded by the second porous region 105B', surrounds the porous region 105C'.

An empty space V is created at the bottom of the second porous region 105B' and is represented by a continuous black line located in the middle of the second porous region 105B'.

The perimeter of the second porous region 105B' can take any shape. It can be a circle, a square, a hexagon, etc.

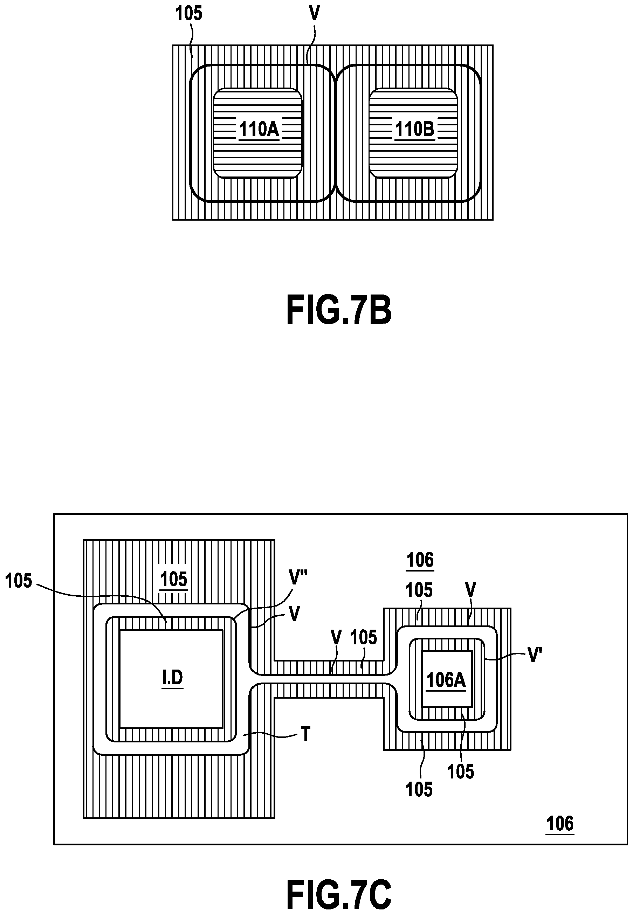

Figure 7B is a top view of two capacitors obtained by implementing the method of the invention. In this example, the whole anodizable metal layer 104 is anodized.

On figure 7B, a first capacitive structure 110A and second capacitive structure 110B are formed in the porous region 105.

An empty space V is created at the bottom of the porous region 105 and is represented by a continuous black line twisting around the two capacitors 110A and 110B.

Figure 7C is a top view of an integrated device ID connected with a conductive track obtained by implementing the method of the invention.

On figure 7C, a porous region 105 is obtained by selectively anodizing the anodizable metal layer 104. A unanodized region 106A is left inside the porous region 105.

A conductive track T is formed in the porous region 105 by etching a pair of empty spaces V and V' at the bottom of the porous region 105. This empty spaces V and V' surround the unanodized region 106A and a zone of the porous region 105 in which an integrated device ID is intended to be formed.

The empty spaces V and V' being parallel to one another, they define the track T, the track T being the band of metal barrier 103, 103B comprised between the two empty spaces V and V'.

### Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

## Claims

1. A method of forming at least one integrated device comprising:
depositing a metal barrier layer (103) on a non-conducting substrate (100),
depositing an anodizable metal layer (104) on the metal barrier layer,
obtaining at least a first porous region (105A) comprising a plurality of substantially straight pores that extend from a top surface of the first porous region towards the metal barrier layer by anodizing the anodizable metal layer (104),
depositing, on the first porous region(105A), an etching mask (EM) having at least one opening (OP) defining an etching zone,
obtaining an insulating region (V) by etching the metal barrier layer located at the bottom of the etching zone through the opening of the etching mask so as to reach the substrate,
forming said integrated device inside the pores of the first porous region.

2. The method according to claim 1, wherein depositing the metal barrier layer comprises:
depositing a first layer of a first metal on the non-conductive substrate, and
depositing at least a second layer made of a second metal on said first layer.

3. The method according to any of claim 1 or 2 comprising, when the etching mask is disposable, a step of removing the etching mask prior to forming said integrated device.

4. The method according to any of claims 1 to 3, further comprising obtaining at least a second porous region (105B), the first and the second porous regions being separated by a first unanodized metal region (106A).

5. An integrated device comprising:
a metal barrier layer (103) on a non-conducting substrate (100),
an anodizable metal layer (104) deposited on the metal barrier layer,
said anodizable metal layer comprising at least a first porous region (105A) comprising a plurality of substantially straight pores that extend from a top surface of the first porous region towards the metal barrier layer,
an insulating region (V), located at the bottom of the first porous region, in which the metal barrier layer was removed so as to reach the substrate.

6. The integrated device according to claim 5, further comprising an etching mask on the anodizable metal layer, said etching mask having at least one opening (OP) located above said insulating region.

7. The integrated device according to claim 6 wherein the etching mask is a hard mask.

8. The integrated device according to claim 6 wherein the etching mask is a resin layer.

9. The integrated device according to anyone of claims 5 to 8, wherein the substrate comprises a plurality of layers, the layer on which the metal barrier layer (103) is deposited being a non-conducting layer.

10. The integrated device according to anyone of claims 5 to 9, wherein the metal barrier layer comprises:
a first layer of a first metal on the non-conductive substrate, and
at least a second layer made of a second metal on said first layer.

11. The integrated device according to anyone of claims 5 to 10, wherein the metal barrier layer is etched so as to obtain at least two electrical contacts connected by at least one conductive line.

12. The integrated device according to anyone of claims 5 to 11, comprising, inside the pores of the porous region, a stacked capacitive structure (110A) comprising a bottom electrode layer (111) in electrical contact with the metal barrier layer at the bottom of the pores, a top electrode layer (113), and a dielectric layer (112) arranged between the bottom and the top electrode layer, so as to form at least one capacitor.

13. A wafer comprising a plurality of integrated devices according to any of claims 5 to 12.
